# EUROPEAN PATENT APPLICATION

(11) **EP 3 657 865 A1**
(43) Date of publication of application: **27.05.2020**
(21) Application number: 18846781.5
(22) Date of filing: 15.08.2018
(51) Int. Cl.: H04W 52/02

(54) **POWER CONSUMPTION CONTROL METHOD AND DEVICE AND COMPUTER READABLE STORAGE MEDIUM**

(30) Priority: 15.08.2017 CN 201710698164
(71) Applicant: ZTE Corporation, Shenzhen, Guangdong 518057 (CN)
(72) Inventor: XU, Jun, Shenzhen Guangdong 518057 (CN); CHEN, Jianqiang, Shenzhen Guangdong 518057 (CN)
(74) Representative: Baudler, Ron
(86) International application number: PCT/CN2018/100640
(87) International publication number: WO 2019/034077

(57) **Abstract**

The disclosure provides a power consumption control method, a power consumption control apparatus and a computer readable storage medium. The power consumption control method comprises the following steps: determining signal strength of a received signal; and determining whether the signal strength of the received signal satisfies a preset strength level, and determining whether to adjust a power of a transmitted signal and a power of the received signal according to the preset strength level when the preset strength level is satisfied.

## Description

### TECHNICAL FIELD

The present disclosure relates to, but is not limited to, the field of communication technology.

### BACKGROUND

At present, intelligent terminals become indispensable tools in people's lives, replace more and more electronic equipment, and market demand thereof is strong. However, as integration of the terminal is higher and higher, functions of the terminal are more and more complex, so that power consumption of the terminal is continuously increased.

A most direct method for solving the power consumption of the terminal is to increase a capacity of a battery, but the capacity of the battery is basically in direct proportion to a volume of the battery, so that a volume of the terminal is increased as a direct result of adopting a high-capacity battery, and use of a user is further influenced. Therefore, it is necessary to consider problems of power consumption and battery capacity when designing the terminal, and it is desirable to reduce power consumption while maintaining the battery capacity, thereby prolonging operating time of the terminal.

### SUMMARY

According to an aspect of the disclosure, a power consumption control method is provided, the power consumption control method includes: determining signal strength of a received signal; and determining whether the signal strength of the received signal satisfies a preset strength level, and determining, when the preset strength level is satisfied, whether to adjust a power of a transmitted signal and a power of the received signal according to the preset strength level.

According to an aspect of the disclosure, a power consumption control apparatus is provided, the power consumption control apparatus includes a processor and a memory, wherein the memory has a computer-readable program stored therein, when the computer readable program is executed by the processor, the processor performs the steps of: determining signal strength of a received signal; and determining whether the signal strength of the received signal satisfies a preset strength level, and determining, when the preset strength level is satisfied, whether to adjust a power of a transmitted signal and a power of the received signal according to the preset strength level.

According to an aspect of the disclosure, a computer-readable storage medium is provided, on the computer readable storage medium, a computer readable program is stored, when the computer readable program is executed by a processor, the processor executes the power consumption control method according to the disclosure.

### BRIEF DESCRIPTION OF THE DRAWINGS

Accompanying drawings are incorporated in to provide a further understanding of embodiments of the disclosure, constitute a part of the specification, are used to explain the disclosure together with the embodiments of the disclosure, and do not constitute a limitation on the disclosure. In the accompanying drawings:
FIG. 1 is a flow chart of a power consumption control method according to an embodiment of the disclosure;
FIG. 2 is a schematic diagram of a circuit of a transmission path and a reception path of a terminal according to an embodiment of the disclosure; and
FIG. 3 is a functional block diagram of a power consumption control apparatus according to an embodiment of the disclosure.

### DETAILED DESCRIPTION

The present disclosure will be further described in detail below with reference to the accompanying drawings and the embodiments. It should be understood that the specific embodiments described herein are merely illustrative of the disclosure and do not limit the disclosure.

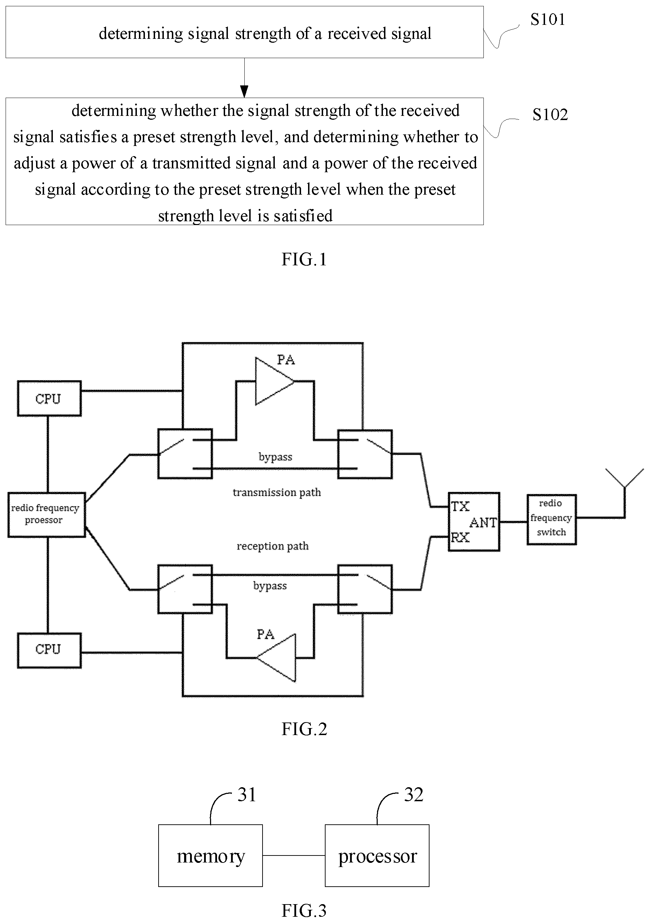

FIG. 1 is a flow chart of a power consumption control method according to an embodiment of the disclosure, and FIG. 2 is a schematic diagram of a circuit of a transmission path and a reception path of a terminal according to an embodiment of the disclosure.

As shown in FIG. 1, the power consumption control method according to an embodiment of the disclosure may include steps S101 and S102.

In step S101, signal strength of a received signal is determined.

In step S102, it is determined whether the signal strength of the received signal satisfies a preset strength level, and it is determined whether to adjust a power of a transmitted signal and a power of the received signal according to the preset strength level when the preset strength level is satisfied.

Referring to FIG. 2, according to an embodiment of the disclosure, transmission paths and reception paths may be provided with two paths respectively. The transmission paths may include a transmission path with a power amplification function and a transmission path without the power amplification function. The transmission path with the power amplification function may perform a power amplification process on the transmitted signal, and the transmission path without the power amplification function does not perform the power amplification process on the transmitted signal. Similarly, the reception paths may include a reception path with low-noise amplification (i.e., a reception path with a power amplification function) and a reception path without the power amplification function. The reception path with the low-noise amplification may amplify the power of the received signal to a preset threshold value, and the reception path without the power amplification function does not perform the power amplification process on the received signal.

According to an embodiment of the disclosure, the preset strength level may include three levels, a first level of signal strength is greater than a second level of signal strength, and the second level of signal strength is greater than a third level of signal strength. According to an embodiment of the disclosure, a range of the first level of signal strength may be set to be greater than -83 dBm, a range of the second level of signal strength may be set to be less than or equal to-83 dBm and greater than -103 dBm, and a range of the third level of signal strength may be set to be less than or equal to -103 dBm.

The received signal is processed through the reception path without the power amplification function when the signal strength of the received signal satisfies the range of the first level of signal strength or the range of the third level of signal strength; and the received signal is subjected to the power amplification process through the reception path with the power amplification function when the signal strength of the received signal satisfies the range of the second level of signal strength.

According to an embodiment of the disclosure, the reception path with the power amplification function may be a reception path with the low-noise amplification, and may increase the signal strength of the received signal to the first level. The first level of signal strength is strong enough that the power amplification process is not required. The third level of signal strength is very weak, and the signal having the third level of signal strength is not amplified any more. Therefore, when the signal strength is strong or very weak, the power amplification process is not performed, so that reception power consumption of a terminal is effectively reduced.

The transmitted signal is subjected to the power amplification process through the transmission path with the power amplification function when the signal strength of the received signal satisfies the range of the third level of signal strength; and the transmitted signal is processed through the transmission path without the power amplification function when the signal strength of the reception signal satisfies the range of the first level of signal strength or the range of the second level of signal strength.

According to an embodiment of the present disclosure, since a closed-loop feedback mechanism exists in the terminal, the power of the transmitted signal may be appropriately adjusted according to the power of the received signal. When the signal strength of the received signal satisfies the range of the second level of signal strength, the received signal is subjected to the power amplification process through the reception path with the low-noise amplification, so that the signal strength of the received signal is increased. Since transmission power may be appropriately reduced based on the closed-loop feedback mechanism and transmission requirement is still satisfied, it is sufficient to process the transmitted signal through the transmission path without the power amplification function, and an effect of reducing power consumption is achieved. When the signal strength of the received signal satisfies the range of the third level of signal strength, the received signal is not subjected to the power amplification process. In order to satisfy the transmission requirement, the transmitted signal needs to be subjected to the power amplification process through the transmission path with the power amplification function. Therefore, only when the signal strength of the received signal is within the range of the third level of signal strength, the transmitted signal is subjected to the power amplification process, and in a case that the signal strength of the received signal is in the range of the first level of signal strength or in the range of the second level of signal strength, the power amplification process is not needed, so that transmission power consumption of the terminal is effectively reduced.

According to an embodiment of the disclosure, by arranging the paths without the power amplification function respectively in the reception path and the transmission path of a mobile terminal and determining whether to perform the power amplification process on the received signal and the transmitted signal according to different strength levels of the received signal, when a specific preset strength level is satisfied, the transmitted signal and the received signal may be processed through the paths without the power amplification function, power consumption caused by the power amplification process is avoided, and operating life of a battery of the terminal is prolonged.

With further reference to FIG. 2, bypasses (i.e., paths without the power amplification function) are provided in the transmission path and the reception path, respectively, for the path with the power amplification function. The bypasses do not perform power amplification process on the transmitted signal or the received signal. Switching between the path with the power amplification function and the bypass may be implemented by a switching element. When a signal of a base station is strong, the bypass may be selected to effectively reduce an emission current and reduce the power consumption; when the base station is far away and the signal of the base station is weak, the received signal is subjected to the power amplification process through the reception path with the low-noise amplification in a receiving circuit, so that receiving sensitivity is effectively improved.

For example, the signal strength of the received signal may be previously classified into three levels, the signal strength greater than -83 dBm is level 1 (i.e., the range of the first level of signal strength), the signal strength less than or equal to -83 dBm and greater than -103 dBm is level 2 (i.e., the range of the second level of signal strength), and the signal strength less than or equal to -103 dBm is level 3 (i.e., the range of the third level of signal strength).

If the signal strength of the received signal is level 1 (i.e., greater than -83 dBm), the received signal is determined to be a strong signal, which may reduce the transmission power due to the closed-loop. An internal program may scan a magnitude of the transmission power, the transmission power may be reduced to about 2dBm, and in this case, the transmission path may be switched to the transmission path without the power amplification function (i.e. the bypass), so as to achieve the effect of reducing the transmission power consumption.

If the signal strength of the received signal is level 2 (i.e., less than or equal to -83 dBm and greater than -103 dBm), the received signal is determined to be a weak signal, in this case, the reception path may be switched to the reception path with the low-noise amplification by a switch, thereby increasing the signal strength of the received signal to amplify the signal strength to greater than -83 dBm. When the signal strength of the received signal increases, the transmission power is forced to reduce to about 2dBm due to the closed-loop. In this case, the transmission path may be switched to the path without the power amplification function (i.e., the bypass), thereby reducing power consumption.

If the signal strength of the received signal is level 3 (i.e., less than or equal to -103 dBm), in this case, the reception path is switched to the path without the power amplification function (i.e., the bypass), while the transmission path may be switched to the transmission path with the power amplification function.

Based on the above, when the signal strength of the received signal is greater than -83 dBm, the reception path is switched to the path without power amplification, and the transmission path is switched to the path without power amplification, so that the transmission power consumption and reception power consumption are reduced; when the signal strength of the received signal is less than or equal to -83 dBm and greater than -103 dBm, the reception path is switched to the reception path with low-noise amplification to amplify the received signal, the transmission power is forced to be reduced and the transmission path is switched to the path without power amplification, so that the transmission power consumption is reduced; when the signal strength of the received signal is lower than -103 dBm, the reception path with low-noise amplification is not used for amplifying the received signal, but the transmission path with power amplification is used for amplifying the transmitted signal, and the reception power consumption is effectively reduced.

FIG. 3 is a functional block diagram of a power consumption control apparatus according to an embodiment of the present disclosure.

As shown in FIG. 3, the power consumption control apparatus according to an embodiment of the present disclosure may include a processor 32 and a memory 31 storing instructions executable by the processor 32.

The processor 32 may be a general purpose processor, such as a central processing unit (CPU), digital signal processor (DSP), application specific integrated circuit (ASIC), etc., or one or more integrated circuits configured to implement the embodiments of the disclosure.

The memory 31 is used for storing program code and to transfer the program code to the processor 32. The memory 31 may include volatile memory, for example, random access memory (RAM), and may also include non-volatile memory, for example, read only memory (ROM), flash memory (Flash), a hard disk drive (HDD), or a solid-state drive (SSD). Further, the memory 31 may include a combination of the above described various memories.

When the processor 32 executes computer readable program stored in the memory 31, the processor 32 may implement the power consumption control method according to the embodiments of the disclosure.

The embodiments of the disclosure also provide a computer readable storage medium having one or more programs stored thereon. The computer readable storage medium may include volatile memory, such as RAM, and may also include non-volatile memory, such as ROM, Flash, HHD, SSD, or the like. Further, the computer readable storage medium may include a combination of the various memories described above. When one or more programs in the computer readable storage medium are executed by one or more processors, the one or more processors may implement the power consumption control method according to the embodiments of the disclosure.

It will be understood by those skilled in the art that the modules or the steps of the embodiments of the disclosure described above may be implemented by a general purpose computing device, and may be centralized on a single computing device or distributed across a network consist of multiple computing devices. Further, the modules or the steps may be implemented by program codes executable by the computing device, thus, the program codes may be stored on a computer storage medium (ROM/RAM, magnetic disks, optical disks) for execution by the computing device. In some cases, the steps shown or described may be performed in an order different than presented herein, or they may be separately fabricated as individual integrated circuit modules, or a plurality of the modules or the steps may be fabricated as a single integrated circuit module. Thus, the disclosure is not limited to any specific combination of hardware and software.

The above description is a more detailed description of the embodiments of the disclosure by taking in conjunction with the specific embodiments thereof, and it is not intended that the disclosure be limited to these specific embodiments. For those ordinary skilled in the art to which the disclosure belongs, without departing from the concept of the disclosure, several simple deductions or replacements may be made and should all be regarded as falling within the protection scope of the disclosure.

## Claims

1. A power consumption control method, comprising:
determining signal strength of a received signal; and
determining whether the signal strength of the received signal satisfies a preset strength level, and determining, when the preset strength level is satisfied, whether to adjust a power of a transmitted signal and a power of the received signal according to the preset strength level.

2. The power consumption control method according to claim 1, wherein
processing the received signal through a reception path without a power amplification function when the signal strength of the received signal satisfies a range of a first level of signal strength or a range of a third level of signal strength; and
performing a power amplification process on the received signal through a reception path with the power amplification function when the signal strength of the received signal satisfies a range of a second level of signal strength,
wherein the first level of signal strength is greater than the second level of signal strength, and the second level of signal strength is greater than the third level of signal strength.

3. The power consumption control method according to claim 1, wherein
performing a power amplification process on the transmitted signal through a transmission path with a power amplification function when the signal strength of the received signal satisfies a range of a third level of signal strength; and
processing the transmitted signal through a transmission path without the power amplification function when the signal strength of the received signal satisfies a range of a first level of signal strength or a range of a second level of signal strength,
wherein the first level of signal strength is greater than the second level of signal strength, and the second level of signal strength is greater than the third level of signal strength.

4. The power consumption control method of claim 2 or 3, wherein the range of the first level of signal strength is greater than -83 dBm, the range of the second level of signal strength is less than or equal to -83 dBm and greater than -103 dBm, and the range of the third level of signal strength is less than or equal to -103 dBm.

5. The power consumption control method of claim 2, wherein the reception path with the power amplification function is a reception path with low-noise amplification.

6. A power consumption control apparatus comprising a processor and a memory, wherein the memory has a computer readable program stored therein, when the computer readable program is executed by the processor, the processor performs the steps of:
determining signal strength of a received signal; and
determining whether the signal strength of the received signal satisfies a preset strength level, and determining, when the preset strength level is satisfied, whether to adjust a power of a transmitted signal and a power of the received signal according to the preset strength level.

7. The power consumption control apparatus of claim 6, wherein the processor performs the steps of:
processing the received signal through a reception path without a power amplification function when the signal strength of the received signal satisfies a range of a first level of signal strength or a range of a third level of signal strength; and
performing a power amplification process on the received signal through a reception path with the power amplification function when the signal strength of the received signal satisfies a range of a second level of signal strength,
wherein the first level of signal strength is greater than the second level of signal strength, and the second level of signal strength is greater than the third level of signal strength.

8. The power consumption control apparatus of claim 6, wherein the processor performs the steps of:
performing a power amplification process on the transmitted signal through a transmission path with a power amplification function when the signal strength of the received signal satisfies a range of a third level of signal strength; and
processing the transmitted signal through a transmission path without the power amplification function when the signal strength of the received signal satisfies a range of a first level of signal strength or a range of a second level of signal strength,
wherein the first level of signal strength is greater than the second level of signal strength, and the second level of signal strength is greater than the third level of signal strength.

9. The power consumption control apparatus of claim 7 or 8, wherein the range of the first level of signal strength is greater than -83 dBm, the range of the second level of signal strength is less than or equal to -83 dBm and greater than -103 dBm, and the range of the third level of signal strength is less than or equal to -103 dBm.

10. The power consumption control apparatus as claimed in claim 7, wherein the reception path with the power amplification function is reception path with low-noise amplification.

11. A computer readable storage medium on which a computer readable program is stored, when the computer readable program is executed by a processor, the processor executes the power consumption control method according to any one of claims 1 to 5.
